# EUROPEAN PATENT APPLICATION

(11) **EP 4 766 089 A1**
(43) Date of publication of application: **24.06.2026**
(21) Application number: 24307132.1
(22) Date of filing: 17.12.2024
(51) Int. Cl.: H10D 84/80, H01L 23/522, H01L 23/66, H03F 1/02, H03F 1/32, H03F 3/193, H03F 3/195

(54) **ON-DIE HARMONIC FILTER CIRCUIT FOR RADIO FREQUENCY AMPLIFIER**

(71) Applicant: NXP USA, Inc., Austin TX 78735 (US)
(72) Inventor: Holin, Raphael, 31023 Toulouse (FR); Peyrot, Pascal, 31023 Toulouse (FR); Hue, Xavier, 31023 Toulouse (FR)
(74) Representative: Schwarzweller, Thomas

(57) **Abstract**

A semiconductor die includes a transistor including a source region, a drain region, a channel between the source region and the drain region, and a gate structure overlying the channel. The gate structure is configured to control a conductivity of the channel vis an electrical voltage applied thereto. The semiconductor die includes a first gate terminal electrically connected to the gate structure and a first harmonic filter inductor formed in a body of the semiconductor die. The first harmonic filter inductor is electrically connected to the first gate terminal. The semiconductor die includes a first harmonic filter capacitor formed in the body of the semiconductor die. The first harmonic filter capacitor includes a first capacitor plate electrically connected to the first harmonic filter inductor and a second capacitor plate connected to a ground reference node.

## Description

### FIELD

The present invention generally relates to radio frequency amplifiers and, more specifically, to radio frequency amplifier die incorporating harmonic filter circuits.

### BACKGROUND

Wireless communication systems employ power amplifiers for increasing the power of radio frequency (RF) signals. In a wireless communication system, a power amplifier forms a portion of the last amplification stage in a transmission chain before provision of the amplified signal to an antenna for radiation over an air interface. High gain, high linearity, stability, and a high level of power-added efficiency are characteristics of a desirable amplifier in such a wireless communication system.

In general, a power amplifier operates at maximum power efficiency when the power amplifier transmits close to saturated power. However, power efficiency tends to worsen as output power decreases. Recently, the Doherty amplifier architecture has been the focus of attention not only for base stations but also for mobile devices because of the architecture's high power-added efficiency over a wide power dynamic range.

The high efficiency of the Doherty architecture makes the architecture desirable for current and next-generation wireless systems. When utilizing the Doherty architecture in power amplifiers, it can be important to provide adequate harmonic signal termination. In many devices, such filtering or termination is provided by circuitry that is external to the semiconductor die containing the power transistors of the amplifier device. This requirement for additional circuitry can interfere with other design goals for Doherty architecture amplifiers, such as relatively low size and cost.

### SUMMARY

This summary section is neither intended to be, nor should be, construed as being representative of the full extent and scope of the present disclosure. Additional benefits, features and embodiments of the present disclosure are set forth in the attached figures and in the description hereinbelow, and as described by the claims. Accordingly, it should be understood that this summary section may not contain all of the aspects and embodiments claimed herein.

Additionally, the disclosure herein is not meant to be limiting or restrictive in any manner. Moreover, the present disclosure is intended to provide an understanding to those of ordinary skill in the art of one or more representative embodiments supporting the claims. Thus, it is important that the claims be regarded as having a scope including constructions of various features of the present disclosure insofar as they do not depart from the scope of the methods and apparatuses consistent with the present disclosure (including the originally filed claims). Moreover, the present disclosure is intended to encompass and include obvious improvements and modifications of the present disclosure.

In some aspects, the techniques described herein relate to a semiconductor die, including: a transistor, including: a source region, a drain region, a channel between the source region and the drain region, a gate structure overlying the channel, wherein an electrical voltage applied to the gate structure is configured to control a conductivity of the channel, and a first gate terminal electrically connected to the gate structure; a first harmonic filter inductor formed in a body of the semiconductor die, wherein the first harmonic filter inductor is electrically connected to the first gate terminal; and a first harmonic filter capacitor formed in the body of the semiconductor die, the first harmonic filter capacitor including a first capacitor plate electrically connected to the first harmonic filter inductor and a second capacitor plate connected to a ground reference node.

In some aspects, the techniques described herein relate to a Doherty amplifier, including: a substrate; an input terminal configured to receive an amplified radio frequency signal; a signal splitter electrically connected to the input terminal and configured to output a first output signal and a second output signal; a semiconductor die on the substrate, wherein the semiconductor die includes: a transistor, a first input bond pad electrically connected to the signal splitter and configured to receive the first output signal, a first harmonic filter inductor formed in a body of the semiconductor die, wherein the first harmonic filter inductor is electrically connected to the first input bond pad, and a first harmonic filter capacitor formed in the body of the semiconductor die, the first harmonic filter capacitor including a first capacitor plate electrically connected to the first harmonic filter inductor.

In some aspects, the techniques described herein relate to an electronic device, including: a substrate; an input terminal configured to receive an amplified radio frequency signal; a signal splitter electrically connected to the input terminal and configured to output a first output signal and a second output signal; a first semiconductor die on the substrate, wherein the first semiconductor die includes: a first transistor, a first input bond pad electrically connected to the signal splitter to receive the first output signal, and a first harmonic filter formed in a body of the first semiconductor die, wherein the first harmonic filter is electrically connected to the first input bond pad; and a second semiconductor die on the substrate, wherein the second semiconductor die includes: a second transistor, a second input bond pad electrically connected to the signal splitter to receive the second output signal, and a second harmonic filter formed in the body of the second semiconductor die, wherein the second harmonic filter is electrically connected to the second input bond pad.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a top view of a traditional Doherty amplifier module.
FIG. 2 depicts a device including a semiconductor die mounted to a substrate.
FIG. 3A depicts a device for providing input harmonic termination.
FIG. 3B is a cross-sectional view of the device of FIG. 3A taken along line 3B-3B of FIG. 3A.
FIG. 4A depicts an alternate implementation of a device for providing input harmonic termination.
FIG. 4B is a cross-sectional view of the device of FIG. 4A taken along line 4B-4B of FIG. 4A.
FIG. 5A depicts another device for providing input harmonic termination.
FIG. 5B is a cross-sectional view of the device of FIG. 5A taken along line 5B-5B of FIG. 5A.
FIG. 6A depicts an alternate device for providing input harmonic termination.
FIG. 6B is a cross-sectional view of the device of FIG. 6A taken along line 6B-6B of FIG. 6A.
FIG. 7A depicts a device for providing input harmonic termination.
FIG. 7B is a cross-sectional view of the device of FIG. 7A taken along line 7B-7B of FIG. 7A.

### DETAILED DESCRIPTION OF THE ILLUSTRATED EMBODIMENTS

The present invention generally relates to radio frequency amplifiers and, more specifically, to radio frequency amplifier die incorporating harmonic filter circuits.

One example of a radio frequency amplifier includes a two-way Doherty amplifier implementation. A Doherty amplifier is an electronic device that includes a radio frequency (RF) signal splitter configured to divide an input RF signal into two signals (referred to as a carrier signal and a peaking signal herein). The amplifier also includes parallel carrier and peaking amplifier paths configured to amplify the carrier and peaking signals, respectively, and a signal combiner configured to combine the amplified carrier and peaking signals. In addition, various phase shift and impedance inversion elements are disposed along the carrier and peaking amplifier paths. For example, in a typical non-inverted Doherty amplifier architecture, a 90 degree phase shift is applied to the peaking signal prior to amplification along the peaking amplifier path, and a corresponding 90 degree phase shift and impedance inversion is applied to the carrier signal after amplification along the carrier amplifier path, and before the amplified carrier and peaking signals are combined together in phase at a combining node.

The carrier amplifier and the peaking amplifier each may be implemented using a single-stage or multiple-stage power transistor. Using nomenclature typically applied to field effect transistors (FETs), the carrier amplifier transistor and the peaking amplifier transistor each may include a plurality of drain and source regions (doped semiconductor regions) in the semiconductor substrate, where a channel region is present between adjacent drain and source regions. A gate structure overlies each channel region. The transistors further include a control terminal (e.g., a gate terminal) configured to receive an input RF signal and provide the signal to the gate structures, and two current conducting terminals (e.g., a drain terminal connected to the drain regions and one or more source terminals connected to the source regions). A voltage applied to the control terminal determines a conductivity of the channel regions between adjacent source and drain regions. In some configurations, each source terminal (and corresponding source region) is coupled to a ground reference node. The amplified carrier and peaking signals are provided at the drain terminals of the carrier amplifier transistor and the peaking amplifier transistor, respectively. For some types of Doherty amplifiers (e.g., 90/0 amplifiers, described below), the drain terminal of the peaking amplifier may serve as the combining node for the amplified RF signals produced by the carrier and peaking amplifiers.

To provide a 90-degree phase shift and an impedance inversion between the drain terminal of the carrier amplifier and the combining node (e.g., at the drain of the peaking amplifier transistor), the drain terminal of the carrier amplifier may be electrically coupled (e.g., with first wirebonds) to the first end of a transmission line, and the second end of the transmission line may be electrically coupled (e.g., with second wirebonds) to the drain terminal of the peaking amplifier (e.g., the combining node). Such a configuration may be referred to as a "90/0" Doherty amplifier, because about 90 degrees of phase shift is applied to the amplified carrier signal before it reaches the combining node, whereas no substantial phase shift is applied to the peaking signal before it reaches the combining node.

In a 90/0 Doherty amplifier, the electrical length of the transmission line between the drain terminals of the carrier and peaking amplifier transistors is determined by the drain capacitances of the transistors and the first and second wirebonds interconnecting the drain terminals to the transmission line. Although a 90 degree total phase shift should be applied between the intrinsic drains of the carrier and peaking amplifier transistors, the electrical length of the transmission line typically has a fixed value that is less than 90 degrees. As such, some amplifier configurations incorporate a shunt inductance circuit coupled to the carrier amplifier transistor drain and/or to the peaking amplifier transistor drain. Essentially, the shunt inductance circuit is configured to allow for increases in the electrical length of the transmission line that interconnects the drain terminals, which in turn may enable the drain terminals to be placed farther apart to minimize coupling between the carrier and peaking paths. According to various embodiments, each of the power transistors in the carrier and peaking amplifiers may be implemented as enhancement-mode or depletion-mode high electron mobility transistors (HEMTs) using III-V semiconductor materials. For example, each transistor may be a III-V field effect transistor (FET), such as a gallium nitride (GaN) FET, or another type of III-V transistor, including a gallium arsenide (GaAs) FET, a gallium phosphide (GaP) FET, an indium phosphide (InP) FET, or an indium antimonide (InSb) FET). In this disclosure, example amplifier implementations are described that relate to GaN transistors, however, it should be understood that embodiments and discussions directed to GaN-based transistors are equally applicable to other types of III-V FETs.

Such technologies may be referred to as high-power or high-power-density technologies and transistors manufactured using such technologies may have reduced drain-source capacitance (Cds) values compared to silicon-based laterally diffused metal oxide semiconductor (LDMOS) transistors, which may result in reduced effectiveness in terminating harmonic frequencies. For example, in a GaN transistor, Cds values can range from about 0.3 picoFarads (pF) to about 3 pF for 10 Watt (W) to 100 W devices. Consequently, Cds values in GaN-based transistors (and other high-power-density transistors) may be as much as 8 times or 10 times lower than Cds values in LDMOS transistors at comparable power levels. In a Doherty amplifier, this results in reduced Cds values for the amplifier's peaking and carrier power transistors, which can, in turn, result in inadequate harmonic termination as compared to amplifiers in an LDMOS implementation. Consequently, without proper carrier harmonic termination, both the efficiency and power output of Doherty amplifiers implemented using GaN or other III-V semiconductor technologies may be degraded. Accordingly, proper carrier harmonic termination is required in high-power Doherty amplifier applications.

In wireless communications application, it is beneficial to provide RF signal amplifiers that exhibit relatively high power-added efficiency (PAE) at output back-off (OBO). Doherty solutions implemented using gallium nitride (GaN)-based transistor devices are sometimes utilized to provide amplifier devices having improved bandwidth and PAE at OBO as compared to other Doherty amplifier systems using other types of transistors. Although providing such benefits, however, GaN technology can be sensitive to harmonic termination throughout the signal chains. Consequently, to extract the best performances out of amplifier devices utilizing this technology, impedances at harmonic frequencies (i.e., harmonic frequencies of the fundamental frequency of the amplifier device) should be carefully optimized and fine-tuned.

In conventional devices, the GaN die periphery is relatively small, so often harmonic filter circuitry (which includes carefully selected inductance/capacitor shunt circuit(s)) is implemented via components that are off-die and connected to the transistor input pad using a wirebonds, which can serve the purpose of the circuit's inductance). Moreover, the capacitors used in such harmonic filter circuits are typically located on the amplifier device's substrate (i.e., not on the die) and are implemented via a separate surface mount devices (SMD) or integrated passive devices (IPD).

Because such conventional harmonic filter circuits are implemented using discrete components that are independent of the transistor die, the circuits often exhibit relatively narrowband harmonic filtering capabilities due to high inductance value of the wire bond or trace connecting the harmonic filter circuit to the input bond pad of the transistor die. Additionally, these circuits can increase overall cost of the amplifier device, due to the need for a separate SMD capacitor and gold wire interconnects, which are typically required to achieve the low inductance values required for harmonic termination of such amplifiers. In addition to these setbacks, these off-die harmonic termination circuits often exhibit performance variation due to variation in die and SMD component placement, variations in wire bond characteristics, and large tolerances present within many SMD devices.

To remedy these difficulties with conventional harmonic termination approaches for GaN-based Doherty amplifier devices, the present disclosure provides a harmonic filter circuit that is integrated directly into the GaN die of the transistor in the amplifier device. Although useable in conjunction with GaN-based amplifiers, it should be understood that the present on-die harmonic filter circuits may be utilized in conjunction with amplifier dies comprising other semiconducting technologies. In this configuration, the inductance of the filter circuit can be precisely controlled to achieve the relatively low inductance values necessary for good harmonic termination performance and further enables improved frequency selectivity of the harmonic filter circuit. In one or more embodiments, the present harmonic filter circuit is relatively compact compared to conventional harmonic filter circuits and can exhibit lower production variation enabling improved RF performance.

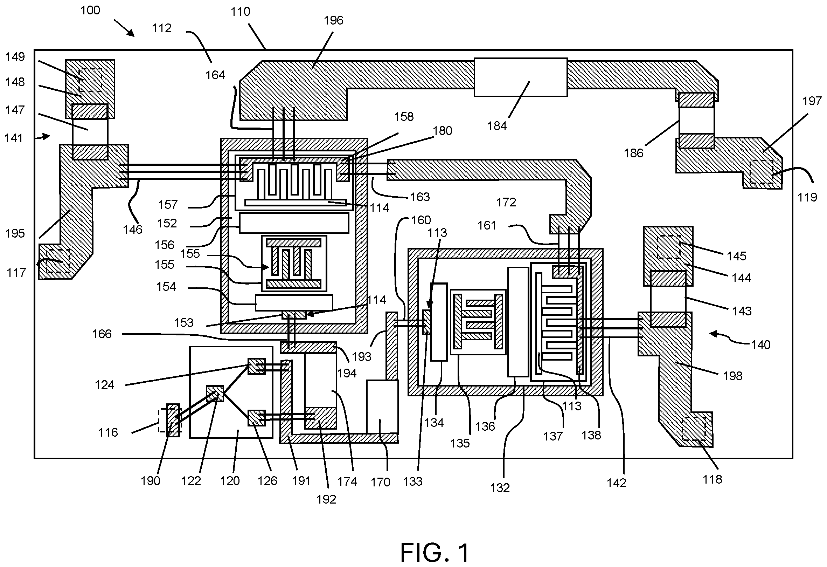

As background, FIG. 1 is a top view of a traditional Doherty amplifier module 100. Doherty amplifier module 100 includes a substrate 110, a power splitter 120, a carrier amplifier die 132, a peaking amplifier die 152, a phase shift and impedance inversion element 172, a first shunt impedance circuit 140 coupled to the carrier amplifier die 132, a second shunt impedance circuit 141 coupled to the peaking amplifier die 152, and various other circuit elements, which will be discussed in more detail below.

Doherty amplifier module 100 may be implemented as a land grid array (LGA) module, for example.

Substrate 110 may be a multi-layer organic substrate (e.g., formed from PCB materials) with a plurality of metal layers which are separated by dielectric material. According to an embodiment, the bottom metal layer is utilized to provide externally accessible, conductive landing pads, where the locations of some example landing pads 116-119, 145, 149 are indicated with dashed boxes in FIG. 1. These landing pads 116-119, 145, 149 (among others, not illustrated) enable surface mounting of the Doherty amplifier module 100 onto a separate substrate (not illustrated) that provides electrical connectivity to other portions of an RF system. Although module 100 is depicted as an LGA module, module 100 alternatively may be packaged as a pin grid array module, a quad flat no leads (QFN) module, or another type of package.

A patterned metal layer may be formed on the mounting surface 112 of the substrate 110. As will be discussed in more detail below, the patterned metal layer may include a plurality of conductive contacts, pad, and traces 144, 148, 190-197 on the mounting surface 112, which facilitates electrical connection to die and other components that may be mounted to the mounting surface 112. In addition, a phase shift and impedance inversion element 172 may be formed from a portion of the patterned metal layer (or from portions of one or more other conductive layers). Conductive vias provide for electrical connectivity between the metal layers.

A conductive landing pad 116 is electrically coupled through the substrate 110 to a conductive contact 190 at the mounting surface 112. The landing pad 116 and contact 190, along with the electrical connections between them, function as the RF input node for the module 100.

The power splitter 120 is coupled to the mounting surface 112. The power splitter 120 includes an input terminal 122 and two output terminals 124, 126. The input terminal 122 is electrically coupled (e.g., through wirebonds, as shown) to conductive contact 190 to receive an input RF signal. In addition, the output terminals 124, 126 are electrically coupled (e.g., through additional wirebonds, as shown) to conductive contacts 191, 192 at the mounting surface 112. The power splitter 120 is configured to split the power of the input RF signal received through input terminal 122 into first and second RF signals (e.g., carrier and peaking signals), which are produced at the output terminals 124, 126. In addition, the power splitter 120 may include a first phase shift element configured to impart about a 90 degree phase shift to the RF signal provided at output terminal 126.

The first and second RF signals may have equal or unequal power. The first RF signal produced at output terminal 124 and conveyed to conductive contact 191 is amplified through a carrier amplifier path. The carrier amplifier path includes an input circuit 170, a carrier amplifier die 132, an impedance inversion element 172 connected to the substrate 110, and a shunt inductance circuit 140 connected to the output terminal 138 of the carrier amplifier die 132. The input circuit 170 is electrically connected between conductive contacts 191 and 193.

Conductive contact 193 is electrically coupled (e.g., with wirebonds 160) to an RF input terminal 133 or input "bond pad" of the carrier amplifier die 132 to provide an RF carrier signal for amplification to the carrier amplifier die 132. The illustrated embodiment of carrier amplifier die 132 embodies a two-stage amplifier. More specifically, the electrical components of carrier amplifier die 132 include an RF input terminal 133, an input matching network 134, a driver transistor 135, an interstage matching network 136, an output transistor 137, and an RF output terminal 138 or output "bond pad". The driver and output transistors 135, 137 are coupled in series between the input and output terminals 133, 138. The driver transistor 135 is configured to apply a relatively low gain to the carrier signal, and the output transistor 137 is configured to apply a relatively high gain to the carrier signal after preliminary amplification by the driver transistor 135. In other embodiments, the carrier amplifier die 132 may embody a single stage amplifier, or may include more than two amplification stages.

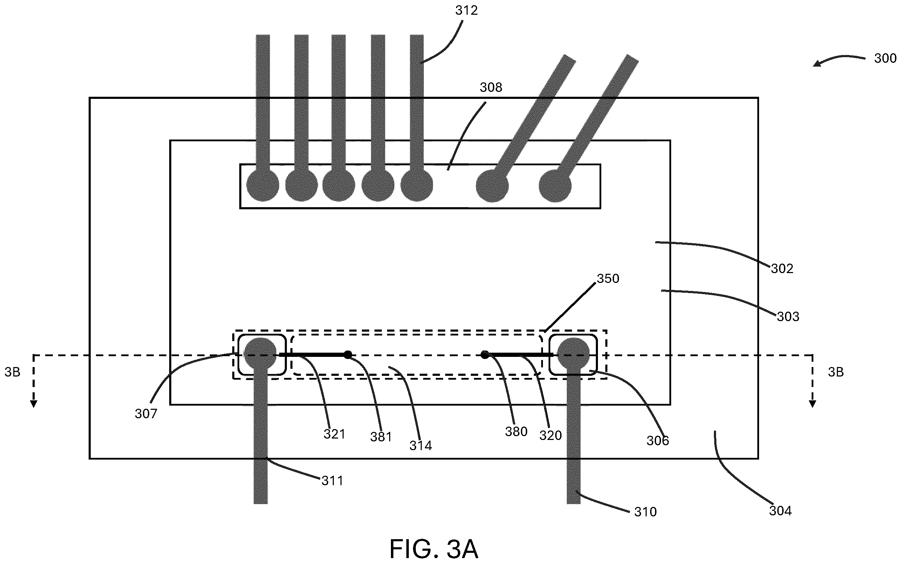

The input terminal 133 of die 132 is electrically coupled to the gate terminal of transistor 135 through input matching network 134, and the drain terminal of transistor 135 is electrically coupled to the gate terminal of transistor 137 through inter-stage matching network 136. As described herein and further illustrated in FIGS. 3A - 7B, the region of the gate terminal of die 132 may include a harmonic filter circuit 113. According to an embodiment, the drain terminal of transistor 137 is electrically coupled to output terminal 138. Accordingly, the signal path through the carrier amplifier die 132 is in a direction extending from the RF input terminal 133 toward the RF output terminal 138.

An amplified RF carrier signal is produced by the carrier amplifier die 132 at the RF output terminal 138. In an embodiment, the RF output terminal 138 is electrically coupled to a first end of phase shift and impedance inversion element 172, which is at least partially exposed at the mounting surface 112, with first wirebonds 161 (i.e., a plurality of parallel, closely spaced wirebonds).

In addition, according to an embodiment, the RF output terminal 138 is electrically coupled through a first shunt inductance circuit 140 to a landing pad 145. The first shunt inductance circuit 140 includes an inductive element in the form of an array of wirebonds 142, in series with a capacitor 143 in the form of a chip capacitor. The wirebonds 142 extend from the RF output terminal 138 to conductive trace 198. Capacitor 143 has a first terminal coupled to the conductive trace 198, and a second terminal coupled to conductive pad 144. The conductive pad 144 is electrically connected through substrate 110 to landing pad 145. When integrated with a larger RF system, landing pad 145 may be connected to system ground.

According to an embodiment, wirebonds 142 are configured to provide an inductance that enables the electrical and physical length of the phase shift and impedance inversion element 172 to be increased, in comparison with the electrical and physical length that may be used if the first shunt inductance circuit 140 were excluded from the module 100. For example, the wirebonds 142 may be configured to have an inductance value in a range of about 1 nH to about 4 nH, for example 1.5 nH, although the wirebonds 142 may be configured to have a smaller or larger inductance value, as well. Although the illustrated embodiment shows the shunt inductive element as a set of two wirebonds 142, other embodiments may include more or fewer wirebonds to achieve a desired inductance value.

Shunt capacitor 143 may have a capacitance value that is chosen to provide a virtual ground reference voltage for the RF electrical signals at conductive trace 198, such that wirebonds 142 function as a shunt inductance to the RF ground voltage. Desirably, the shunt capacitor 143 is series resonant in band. For example, shunt capacitor 143 may have a capacitance value of about 15 pF to about 27 pF, for example 22 pF, or more specifically in a range of about 20 pF to about 24 pF, although the capacitance value may be smaller or larger, as well.

Trace 198 may be used to provide a DC bias voltage to the output terminal 138 of transistor 137. Accordingly, in an embodiment, trace 198 also may be coupled through the substrate 110 to landing pad 118. Landing pad 118, in turn, may be coupled to a drain bias circuit in the RF system to which module 100 ultimately is connected.

RF output terminal 138 of carrier amplifier die 132 includes an elongated first pad that is configured to enable wirebonds 161 to be connected to the first pad so that the wirebonds 161 extend in a direction that is angularly offset from (e.g., perpendicular to) the direction of the signal path through the carrier amplifier die 132. Further, the RF output terminal 138 may include an elongated second pad that is configured to enable the wirebonds 142 corresponding to the shunt inductive element of the shunt inductance circuit 140 to be connected to the second pad so that the wirebonds 142 extend in a direction that is parallel to, or substantially parallel to, the direction of the signal path through the carrier amplifier die 132.

As mentioned above, through wirebonds 161, the RF output terminal 138 is electrically coupled to phase shift and impedance inversion element 172. According to an embodiment, phase shift and impedance inversion element 172 is implemented with a transmission line (e.g., a microstrip line) having an electrical length of about lambda/4 (λ/4) or less. The transmission line has a first end that is proximate to the carrier amplifier die 132 (and more particularly within a wirebond length of the RF output terminal 138), and a second end that is proximate to the peaking amplifier die 152 (and more particularly within a wirebond length of the RF output terminal 158 of the peaking amplifier die 152).

Moving back to the power splitter 120, the second RF signal (i.e., the peaking signal) produced at output terminal 126 of the power splitter 120 and conveyed to conductive contact 192 is amplified through a peaking amplifier path. The peaking amplifier path includes input circuit 174, a peaking amplifier die 152, and a shunt inductance circuit 141 connected to the output terminal 158 of the peaking amplifier die 152. As mentioned above, the power splitter 120 may impart about a 90 degree phase shift to the RF signal provided at output terminal 126. Accordingly, the phase of the peaking signal received at input terminal 153 of peaking die 152 is delayed by about 90 degrees with respect to the carrier signal received at input terminal 133 of carrier die 132.

The input circuit 174 is electrically connected between conductive contacts 192 and 194. Conductive contact 194 is electrically coupled (e.g., with wirebonds 166) to an RF input terminal 153 of the peaking amplifier die 152, to provide an RF signal for amplification to the peaking amplifier die 152. The illustrated embodiment of peaking amplifier die 152 also embodies a two-stage amplifier. More specifically, the electrical components of peaking amplifier die 152 include an RF input terminal 153, an input matching network 154, a driver transistor 155, an interstage matching network 156, an output transistor 157, and an RF output terminal 158. The driver and output transistors 155, 157 are coupled in series between the input and output terminals 153, 158. The driver transistor 155 is configured to apply a relatively low gain to the peaking signal, and the output transistor 157 is configured to apply a relatively high gain to the peaking signal after preliminary amplification by the driver transistor 155. In other embodiments, the peaking amplifier die 152 may embody a single stage amplifier or may include more than two amplification stages. Again, each of the transistors 155, 157 may be a FET or a BJT.

As depicted in FIG. 1, transistors 155, 157 of peaking amplifier die 152 are configured as power transistors that each include one or more transistor fingers, that each includes a plurality of individual transistors connected in parallel between input and output terminals of each transistor 155, 157. Although these parallel-connected transistors enable each transistor 155, 157 to modulate and carry higher power signals, the individual transistors constitute separate and isolated conduction paths through which current flows through transistors 155, 157. As described herein and further illustrated in FIGS. 3A - 7B, the region of the gate terminal of die 152 may include a harmonic filter circuit 114.

Input terminal 153 or input "bond pad" of die 152 is electrically coupled to the gate terminal of transistor 155 through input matching network 154, and the drain terminal of transistor 155 is electrically coupled to the gate terminal of transistor 157 through inter-stage matching network 156. As described herein, the gate terminal of transistor 155 may include a harmonic filter circuit 114. According to an embodiment, the drain terminal of transistor 157 is electrically coupled to output terminal 158 or output "bond pad". Accordingly, the signal path through the carrier amplifier die 152 is in a direction extending from RF input terminal 153 toward RF output terminal 158.

An amplified RF peaking signal is produced by the peaking amplifier die 152 at the RF output terminal 158. In an embodiment, and as mentioned above, the RF output terminal 158 is electrically coupled to impedance inversion element 172 with wirebonds 163, and RF output terminal 158 functions as a combining node 180 at which the amplified and delayed carrier amplifier signal is combined, in phase, with an amplified peaking amplifier signal.

In addition, according to an embodiment, the RF output terminal 158 is electrically coupled through a second shunt inductance circuit 141 to a landing pad 149. The second shunt inductance circuit 141 includes an inductive element in the form of a set of wirebonds 146, in series with a capacitor 147. The wirebonds 146 extend from the RF output terminal 158 to conductive trace 195. Capacitor 147 has a first terminal coupled to the conductive trace 195, and a second terminal coupled to conductive pad 148. The conductive pad 148 is electrically connected through the substrate 110 to landing pad 149. When integrated with a larger RF system, landing pad 149 may be connected to system ground.

Wirebonds 146 are configured to enable the electrical and physical length of the phase shift and impedance inversion element 172 to be increased, in comparison with the electrical and physical length that may be used if the first shunt inductance circuit 141 were excluded from the module 100. For example, the wirebonds 146 may be configured to have an inductance value in a range of about 1 nH to about 4 nH (e.g., 1.5 nH), although the wirebonds 146 may be configured to have a smaller or larger inductance value, as well. Although the illustrated embodiment shows the shunt inductive element as a set of two wirebonds 146, other embodiments may include more or fewer wirebonds to achieve a desired inductance value. Further, the inductance value may be controlled through variation of the loop heights of the wirebonds 146.

As discussed previously, the shunt capacitor 147 has a capacitance value that is chosen to provide a virtual ground reference voltage for the RF electrical signals at conductive trace 195, such that wirebonds 146 function as a shunt inductance to the RF ground voltage. Desirably, the shunt capacitor 147 is series resonant in band. For example, shunt capacitor 147 may have a capacitance value of about 22 pF, although the capacitance value may be smaller or larger, as well.

Because conductive trace 195 corresponds to an in-band RF low impedance node, in an embodiment, conductive trace 195 may be used to provide a DC bias voltage to the output terminal 158 of transistor 157. Accordingly, in an embodiment, conductive trace 195 also may be coupled through the substrate 110 to landing pad 117. Landing pad 117, in turn, may be coupled to a drain bias circuit in the RF system to which module 100 ultimately is connected.

The signal path through the peaking amplifier die 152 is in a direction extending from the RF input terminal 153 to the RF output terminal 158. As can be seen in FIG. 1, the signal paths through the peaking and carrier amplifier die 152, 132 extend in significantly different directions, and more particularly the signal paths are perpendicular in the embodiment of FIG. 1.

According to an embodiment, except for the configurations of the RF output terminals 138, 158, the peaking amplifier die 152 may be structurally identical to the carrier amplifier die 132, meaning that the two die 132, 152 include the same structural and electrical elements arranged and interconnected in the same manner. According to a further embodiment, the peaking amplifier die 152 and the carrier amplifier die 132 can be identical in size, rendering the Doherty amplifier module 100 a symmetric Doherty amplifier. In an alternate embodiment, the peaking amplifier die 152 and the carrier amplifier die 132 may have different sizes, rendering the Doherty amplifier module 100 an asymmetric Doherty amplifier. For example, the peaking amplifier die 152 may be larger than the carrier amplifier die 132 by a ratio (e.g., 1.6:1, 2:1, or some other ratio).

Through wirebonds 163, RF output terminal 158 is electrically coupled to phase shift and impedance inversion element 172. Accordingly, the amplified carrier signal produced by the carrier amplifier die 132 is received at the RF output terminal 158 of the peaking amplifier die 152 through wirebonds 161, phase shift and impedance inversion element 172, and wirebonds 163. The amplified peaking signal produced by the peaking amplifier die 152 also is received at the RF output terminal 158, and the module 100 is configured so that the amplified carrier and peaking signals arrive and are combined at output terminal 158 (or combining node 180) in phase with each other.

According to an embodiment, the RF output terminal 158 (or combining node 180) is electrically coupled to conductive output trace 196 at the mounting surface 112 with wirebonds 164. As illustrated in FIG. 1, the wirebonds of the wirebonds 164 are aligned in the same direction as the RF signal path through the peaking amplifier die 152. In an embodiment, wirebonds 163, 164 are perpendicularly arranged with respect to each other at adjacent sides of die 152, wirebonds 146, 164 also are perpendicularly arranged with respect to each other at adjacent sides of die 152, and wirebonds 163, 146 are arranged in parallel with each other at opposing sides of the peaking amplifier die 152. Accordingly, even though the wirebonds 163, 164 and wirebonds 146, 164 may be positioned relatively close together, their perpendicular orientations may significantly reduce coupling of RF signals carried through the wirebonds 146, 163, 164.

An output impedance matching network 184 (also referred to as an output transformer) and/or a decoupling capacitor 186 may be coupled along output trace 196, in an embodiment. The output impedance matching network 184 functions to present the proper load impedance to combining node 180. Although the detail is not shown in FIG. 1, the output impedance matching network 184 may include various discrete and/or integrated components (e.g., capacitors, inductors, and/or resistors) to provide the desired impedance matching. The output impedance matching network 184 is electrically coupled through the substrate 110 to conductive landing pad 119. The landing pad 119 functions as the RF output node for the module 100.

Besides the bias circuitry connections previously discussed (e.g., including elements 117, 118, 195, 198), module 100 also may include additional bias circuitry and/or bias circuitry connections configured to provide gate and drain bias voltages to some or all of the driver and output transistors 135, 155, 137, 157. For example, the bias circuitry may include, among other things, a plurality of landing pads, contacts (at the mounting surface 112 of the substrate 110), and other conductive structures and circuitry. Bias voltages provided to the gates and/or drains of the transistors 135, 155, 137, 157 facilitate Doherty operation of the module. For example, the transistors 135, 137 of the carrier amplifier die 132 may be biased to operate in class AB mode, and the transistors 155, 157 of the peaking amplifier die 152 may be biased to operate in class C mode. The above-described configuration corresponds to a non-inverted Doherty amplifier. In an alternate embodiment, modifications could be made to configure the module 100 to function as an inverted Doherty amplifier. The inverted Doherty configuration places the 90 degree delay element on the carrier amplifier portion of the amplifier signal path and a 0 degree delay element on the peaking amplifier portion of the amplifier signal path. The carrier output 90 degree shift combines with the peaking output which has a 180 degree shift. This inverted Doherty configuration can also be referred to as 90-180 Doherty.

In various implementations of module 100, input-side harmonic filter circuits 113, 114 may be incorporated into the input bond pad regions of one or more of carrier amplifier die 132 and peaking amplifier die 152 to provide termination of the signal components of input signals to either die at frequencies that are harmonic frequencies of a fundamental frequency of operation of the Doherty amplifier housed within module 100 (e.g., signal energy at one or more harmonic frequencies that is included in the input signals).

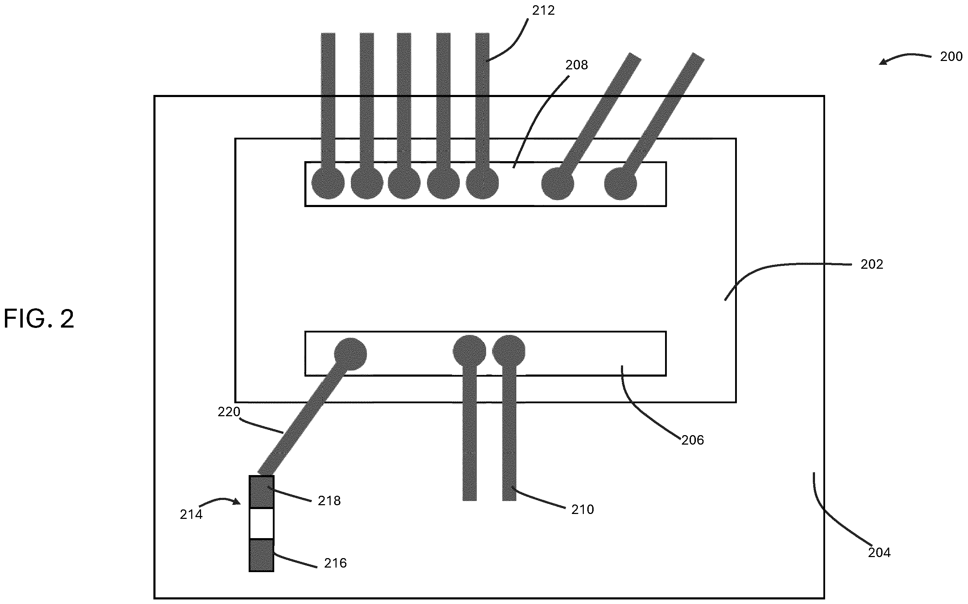

In conventional approaches, such harmonic filter circuits are implemented by components that are external to the amplifier die and that include separate wirebonds or traces (for the inductive elements of the termination circuits) and SMD or IPD-based capacitors. To illustrate, FIG. 2 depicts a device 200 including semiconductor die 202 mounted to a substrate 204. In one or more embodiments, semiconductor die 202 includes a transistor configured to amplify an input RF signal.

Semiconductor die 202 includes bond pad 206 that is configured to operate as an RF input terminal of semiconductor die 202. Semiconductor die 202 also includes bond pad 208 that is configured to operate as an RF output terminal of semiconductor die 202.

Wirebonds 210 are coupled to bond pad 206 and are configured to supply an input RF signal to bond pad 206 and the power transistor of semiconductor die 202. Specifically, bond pad 206 is coupled to a gate or control terminal of the transistor of semiconductor die 202. Wirebonds 212 are similarly connected to bond pad 208 and are configured to route the amplified RF output signal of semiconductor die 202 to other components.

During operation, the RF input signal that is supplied to bond pad 206 (and to the RF input terminal) of semiconductor die 202 may include harmonic signal components that should be terminated (e.g., shunted to ground) to enable efficient amplification of the signal by semiconductor die 202. Accordingly, a harmonic filter circuit is coupled to the input bond pad 206, and the harmonic filter circuit is configured to shunt the signal energy at one or more harmonic frequencies to a ground node, effectively removing them from the signal that is amplified by semiconductor die 202.

Within the filter circuit, capacitor 214 is mounted to substrate 204. Capacitor 214 is a discrete component and may include an SMD capacitor or IPD having capacitive properties, for example. Capacitor 214 includes terminal 216 which is connected to a ground node (e.g., connected to a ground plane by means of a conductive via formed through substrate 204) putting the filter circuit in a shunt configuration. The other terminal 218 of capacitor 214 is connected to a first end of wirebond 220. The second end of wirebond 220 is connected to bond pad 206. In this configuration, wirebond 220 operates as an inductance, so together wirebond 220 and capacitor 214 form a series inductance-capacitor shunt termination circuit. By appropriately designing the inductance of wirebond 220 and the capacitance of capacitor 214, wirebond 220 and capacitor 214 work in conjunction as a harmonic filter circuit configured to shunt to a ground node any signal energy present at bond pad 206 that are at harmonic frequencies of the fundamental frequency of semiconductor die 202.

Although the arrangement illustrated in FIG. 2 can be used to provide harmonic termination for the die 202, the circuit has drawbacks, as detailed above, that include the relatively large size of the circuit resulting from wirebond 220 and capacitor 214 being separate and distinct components from semiconductor die 202.

In the present disclosure, as described below, alternative approaches for harmonic filter circuits are presented in which the inductance and capacitance of the filter circuits are incorporated directly into the body of the semiconductor die containing the amplifier transistor. The approach can be used, for example, in conjunction with carrier amplifier die 132 or peaking amplifier die 152 of FIG. 1 to provide harmonic termination for the various amplifiers of a Doherty amplifier.

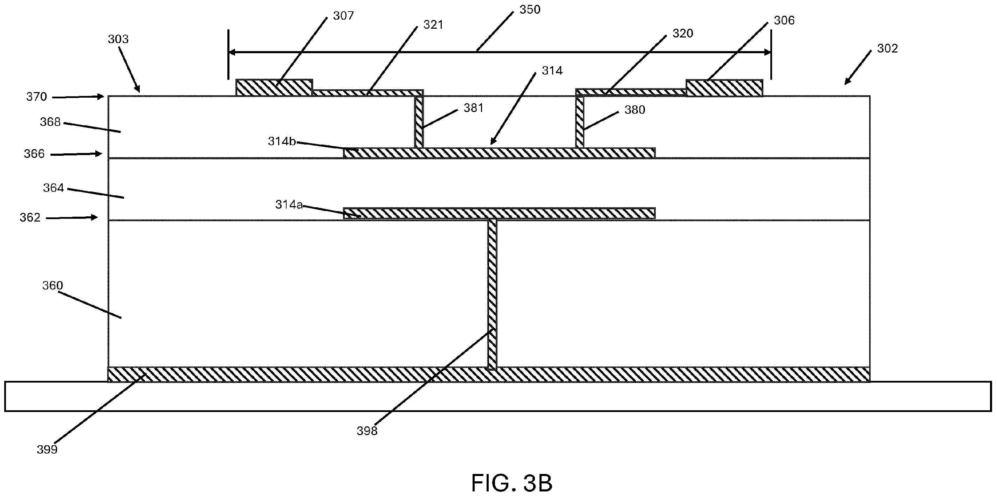

To illustrate, FIG. 3A depicts a device 300 for providing improved harmonic termination. FIG. 3B is a cross-sectional view of device 300 taken along line 3B-3B of FIG. 3A. Device 300 includes semiconductor die 302 (e.g., carrier amplifier die 132 or peaking amplifier die 152) mounted to substrate 304 (e.g., substrate 110 of FIG. 1). In some embodiments, the die 302 is more specifically mounted to a conductive feature of substrate, such as a conductive coin or thermal vias, which function as a ground node and/or thermal dissipation structure. In one or more embodiments, semiconductor die 302 includes a transistor (e.g., a GaN transistor or another type of transistor) configured to amplify an input RF signal.

Semiconductor die 302 includes a first bond pad 306 and a second bond pad 307 are both configured to operate as an RF input terminal (e.g., RF input terminal 153 of FIG. 1) of semiconductor die 302. Bond pads 306 and 307 may, in one or more embodiment, be gate structures of the transistor of semiconductor die 302. Or, alternatively, may be distinct from, but electrically connected to (e.g., via a matching network) the transistor's gate structure. Semiconductor die 302 also includes bond pad 308 that is configured to operate as an RF output terminal (e.g., RF output terminal 158 or RF output terminal 138 of FIG. 1) of semiconductor die 302, for example, to output an amplified radio frequency signal. On top surface 303 of semiconductor die 302, both bond pads 306 and 307 are formed within a region of top surface 303 designated as an input bond pad region 350. The input bond pad region 350 represents the portion of top surface 303 of semiconductor die 302 that, in a conventional application, would be reserved and allocated for a single input bond pad, as in the configuration of bond pad 206 of device 200 of FIG. 2.

As illustrated by FIG. 3A, however, the input bond pads 306 and 307 of device 300 occupy only a small portion of input bond pad region 350, leaving the remainder of the input bond pad region 350 and the portion of the semiconductor die that is below the input bond pad region 350 available for the fabrication of other components as described below. Input bond pad region 350 is generally of the size and shape of a conventional bond pad used in conjunction with semiconductor die 302. As such, input bond pad region 350 may, in various embodiments of the present disclosure, have a same or similar length and width as bond pad 308. According to one or more embodiments, no portion of the below-described harmonic filter circuit is outside a portion of the semiconductor die defined by the input bond pad region 350.

Wirebonds 310 and 311 are coupled to bond pads 306 and 307, respectively, and are configured to supply an input RF signal to bond pads 306 and 307 and the power transistor of semiconductor die 302. Specifically, bond pads 306 and 307 are each electrically coupled to a gate or control terminal of the transistor of semiconductor die 302. Wirebonds 312 are similarly connected to bond pad 308 and are configured to route the amplified RF output signal of semiconductor die 302 to other components (e.g., wirebonds 164 or wirebonds 142 of FIG. 1). Bond pad 308 is electrically coupled to the drain or output terminal of the transistor within semiconductor die 302.

During operation, the RF input signal that is supplied to bond pads 306 and 307 (i.e., the RF input terminal) of semiconductor die 302 may include harmonic components (i.e., signal energy at one or more harmonic frequencies) that should be terminated to enable efficient amplification of the signal by semiconductor die 302. Accordingly, a harmonic filter circuit is coupled to bond pads 306 and 307 that is configured to shunt those harmonic components to a ground node, effectively removing them from the signal that is amplified by semiconductor die 302.

An "active area" of the semiconductor die 302 is a portion of the die in which active transistor regions are present (e.g., gate structures, drain regions, and source regions). Conversely, a "non-active area" of the semiconductor die 302 is a portion of the die in which active transistor regions are not present. Within the harmonic filter circuit, capacitor 314 is formed within a non-active area of semiconductor die 302, and more specifically within the input bond pad region 350. As shown by FIG. 3B, semiconductor die 302 includes a number of layers, which may include alternating layers of semiconductor materials, dielectric materials, and patterned metal layers arranged or patterned to form the functional components of semiconductor die 302. Specifically, semiconductor die 302 includes a lower layer 360 of semiconductor material(s), which forms a base of semiconductor die 302, and a build-up structure over the lower layer 360. The build-up structure includes patterned metal layer 362, which is formed over layer 360. Dielectric layer 364 is formed over metal layer 362, and patterned metal layer 366 is formed over dielectric layer 364. Dielectric layer 368 is formed over metal layer 366, and patterned metal layer 370 is formed over dielectric layer 368. Another conductive layer 399 may be formed on the bottom surface of the semiconductor die 302, and this layer functions as a ground reference node for the die 302.

Capacitor 314, which may be referred to as a "harmonic filter capacitor," is formed using patterned portions of metal layers 362 and 366 of semiconductor die 302 that are below top surface 303 of semiconductor die 302. Specifically, capacitor 314 includes a bottom plate 314a that is connected to a ground node (e.g., via a conductive network that may include, for example, a conductive through substrate via 398 that extends through layer 360 to conductive layer 399 and a conductive ground node in the substrate 304 (not shown in FIG. 3A or 3B)) Top plate 314b of capacitor 314 is connected, by conductive via 380, to a first end of conductive trace 320 (e.g., which may be implemented as a linear conductor (as depicted) or, alternatively, as a spiral inductor), which is coupled at its other end to bond pad 306. In a similar manner, top plate 314b of capacitor 314 is connected, by via 381, to a first end of conductive trace 321 (e.g., which may be implemented as a linear conductor (as depicted) or, alternatively, as a spiral inductor), which is coupled at its other end to bond pad 307. Conductive traces 320 and 321 are formed at the top surface 303 of semiconductor die 302 in metal layer 370, in an embodiment, although they may be formed in underlying metal layers, as well.

In this configuration, conductive trace 320 operates as an inductance, and thus trace 320 may be referred to herein as a "harmonic filter inductor". Together, conductive trace 320 and capacitor 314 (which comprises two capacitor plates referred to as bottom plate 314a, top plate 314b, and a portion of dielectric layer 364 disposed between bottom plate 314a and top plate 314b) form a series inductance-capacitor shunt circuit. By designing the inductance of conductive trace 320 (and conductive via 380) and the capacitance of capacitor 314, conductive trace 320 and capacitor 314 work in conjunction as a harmonic filter circuit configured to shunt to a ground node any signal energy present at bond pad 306 that is at a harmonic frequency (e.g., a second or higher order harmonic of the fundamental frequency of operation of semiconductor die 302).

Similarly, conductive trace 321 operates as an inductance, and thus trace 321 may be referred to herein as a "harmonic filter inductor". Together, conductive trace 321 and capacitor 314 form a series inductance-capacitor shunt circuit. By designing the inductance of conductive trace 321 (and conductive via 381) and the capacitance of capacitor 314, conductive trace 321 and capacitor 314 work in conjunction as a harmonic filter circuit configured to shunt to a ground node any signal energy present at bond pad 307 that is at a harmonic frequency (e.g., a second or higher order harmonic of the fundamental frequency of operation of semiconductor die 302).

The harmonic filter circuits comprising conductive trace 320, capacitor 314, and conductive trace 321 are, as illustrated in FIGs 3A and 3B, incorporated into the body of semiconductor die 302. This enables better control over both the inductance values of conductive trace 320 and conductive trace 321 as well as the capacitance of capacitor 314 to improve the efficiency and performance of semiconductor die 302.

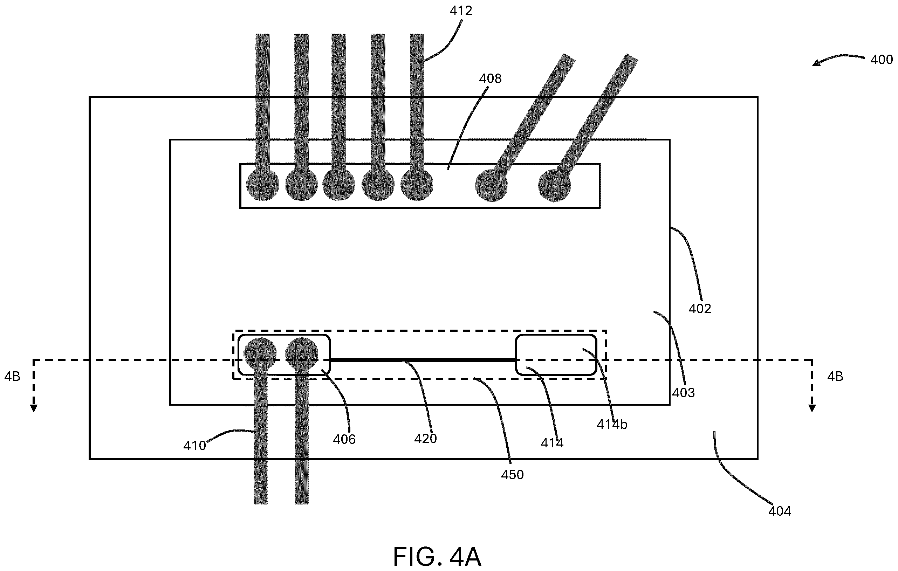

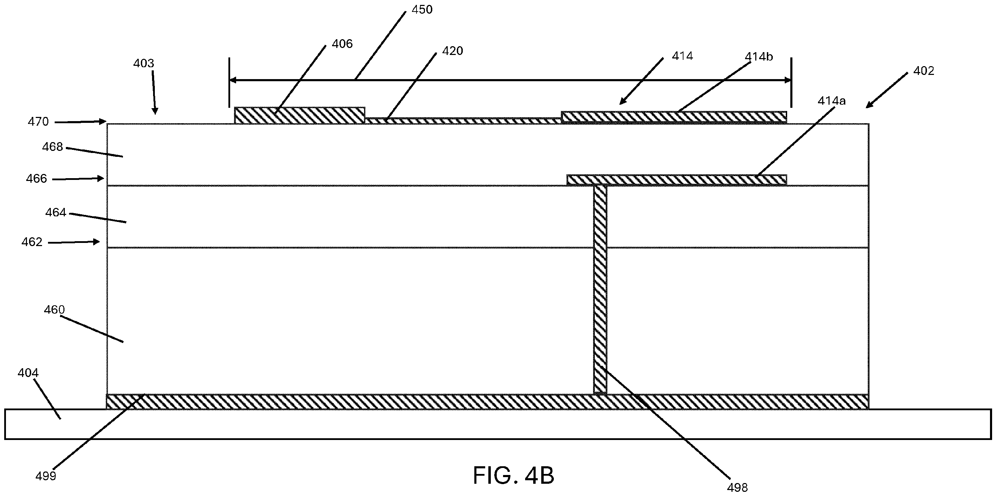

FIG. 4A depicts an alternate implementation of a device 400 for providing improved harmonic termination. FIG. 4B is a cross-sectional view of device 300 taken along line 4B-4B of FIG. 4A. Device 400 includes semiconductor die 402 (e.g., carrier amplifier die 132 or peaking amplifier die 152 of FIG. 1) mounted to substrate 404 (e.g., substrate 110 of FIG. 1). In some embodiments, the die 402 is more specifically mounted to a conductive feature of substrate, such as a conductive coin or thermal vias, which function as a ground node and/or thermal dissipation structure. In one or more embodiments, semiconductor die 402 includes a transistor (e.g., a GaN transistor or other type of transistor) configured to amplify an input RF signal.

Semiconductor die 402 includes bond pad 406 that is configured to operate as an RF input terminal (e.g., RF input terminal 153 of FIG. 1) of semiconductor die 402. Bond pad 406 may, in one or more embodiment, be a gate structure of the transistor of semiconductor die 402. Or, alternatively, may be distinct from, but electrically connected to (e.g., via a matching network) the transistor's gate structure. On top surface 403 of semiconductor die 402, bond pad 406 is formed within a region of top surface 403 designated as the input bond pad region 450. The input bond pad region 450 represents the portion of top surface 403 of semiconductor die 402 that, in a conventional application, would be reserved and allocated for a single input bond pad, as in the configuration of bond pad 206 of device 200 of FIG. 2.

As illustrated by FIG. 4A, however, the input bond pad 406 of device 400 occupies only a small portion of input bond pad region 450, leaving the remainder of the input bond pad region 450 and the portion of semiconductor die 402 below the input bond pad region 450 available for the fabrication of other components as described below. Input bond pad region 450 is generally of the size and shape of a conventional bond pad used in conjunction with semiconductor die 402. As such, input bond pad region 450 may, in various embodiments of the present disclosure, have the same or a similar length and width as bond pad 408, for example, to output an amplified radio frequency signal. According to one or more embodiments, no portion of the below-described harmonic filter circuit is outside a portion of the semiconductor die defined by the input bond pad region 450.

Semiconductor die 402 includes bond pad 408 that is configured to operate as an RF output terminal (e.g., RF output terminal 158 or RF output terminal 138 of FIG. 1) of semiconductor die 402.

Wirebonds 410 are coupled to bond pad 406 and are configured to supply an input RF signal to bond pad 406 and the power transistor of semiconductor die 402. Specifically, bond pad 406 is coupled to a gate or control terminal of the transistor of semiconductor die 402. Wirebonds 412 are similarly connected to bond pad 408 and are configured to route the amplifier RF output signal of semiconductor die 402 to other components (e.g., wirebonds 164 or wirebonds 142 of FIG. 1). Bond pad 408 is electrically coupled to the drain or output terminal of the transistor within semiconductor die 402.

During operation, the RF input signal that is supplied to bond pad 406 (i.e., the RF input terminal) of semiconductor die 402 includes harmonic components that should be terminated to enable efficient amplification of the signal by semiconductor die 402. Accordingly, a harmonic filter circuit is coupled to bond pad 406 that is configured to shunt those harmonic components to a ground node, effectively removing them from the signal that is amplified by semiconductor die 402.

Accordingly, capacitor 414 is formed within a non-active area of semiconductor die 402 within the input bond pad region 450. As shown by FIG. 4B, semiconductor die 402 includes a number of layers, which may include alternating layers of semiconductor materials, dielectric materials, and patterned metal layers arranged or patterned to form the functional components of semiconductor die 402. Specifically, semiconductor die 402 includes a lower layer 460 of semiconductor material(s), which forms a base of semiconductor die 402, and a build-up structure over the lower layer 460. The build-up structure includes patterned metal layer 462 is formed over dielectric layer 460. Dielectric layer 464 is formed over metal layer 462 and metal layer 466 is formed over dielectric layer 464. Dielectric layer 468 is formed over metal layer 466 and metal layer 470 is formed over dielectric layer 468. Another conductive layer 499 may be formed on the bottom surface of the semiconductor die 402, and this layer functions as a ground reference node for the die 402.

Capacitor 414, which may be referred to as a "harmonic filter capacitor," is formed within metal layers 466 and 470 of semiconductor die 302. Specifically, capacitor 414 includes a bottom plate 414a formed in metal layer 466 (or, alternatively, metal layer 462) that is connected to a ground node (e.g., via a conductive network that may include, for example, a conductive through substrate via 498 that extends through layers 460 and 464 to a conductive layer 499 on the bottom surface of the die that functions as a ground reference node for the die 402). Top plate 414b of capacitor 414 is connected to a first end of conductive trace 420 (which is also formed in metal layer 466 such that trace 420 and top plate 414b could be formed by a single patterned region of metal layer 466), which is coupled at its other end to bond pad 406. In a similar manner, In this configuration, conductive trace 420 (e.g., which may be implemented as a linear conductor (as depicted) or, alternatively, as a spiral inductor) operates as an inductance, and thus trace 420 may be referred to herein as a "harmonic filter inductor". Together, conductive trace 420 and capacitor 414 form a series inductance-capacitor shunt circuit. By designing the inductance of conductive trace 420 and the capacitance of capacitor 414, conductive trace 420 and capacitor 414 work in conjunction as a harmonic filter circuit configured to shunt to a ground node any signals present at bond pad 406 that are at harmonic frequencies of the fundamental frequency of semiconductor die 402.

The harmonic filter circuit comprising conductive trace 420 and capacitor 414 are, as illustrated in FIG. 4A and 4B, incorporated into the body of semiconductor die 402. This enables better control over both the inductance values of conductive trace 420 as well as the capacitance of capacitor 414 to improve the efficiency and performance of semiconductor die 402.

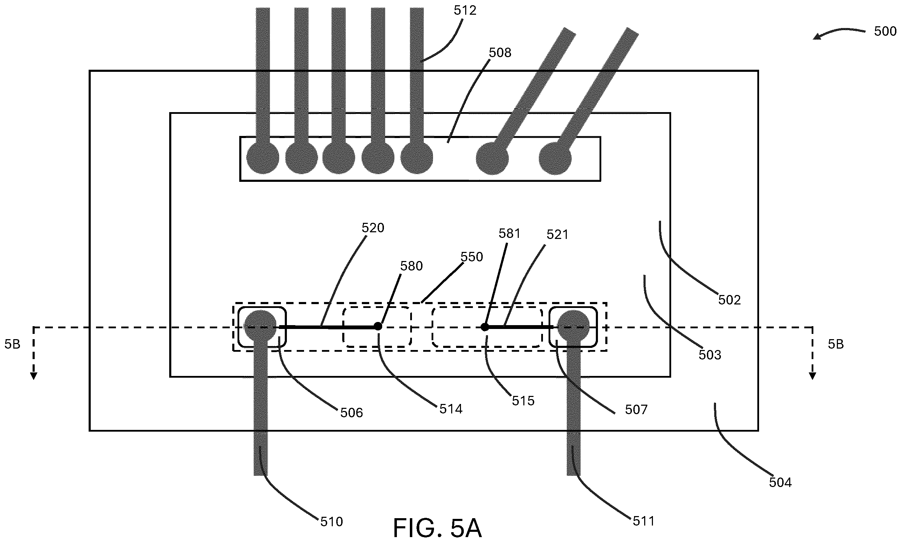

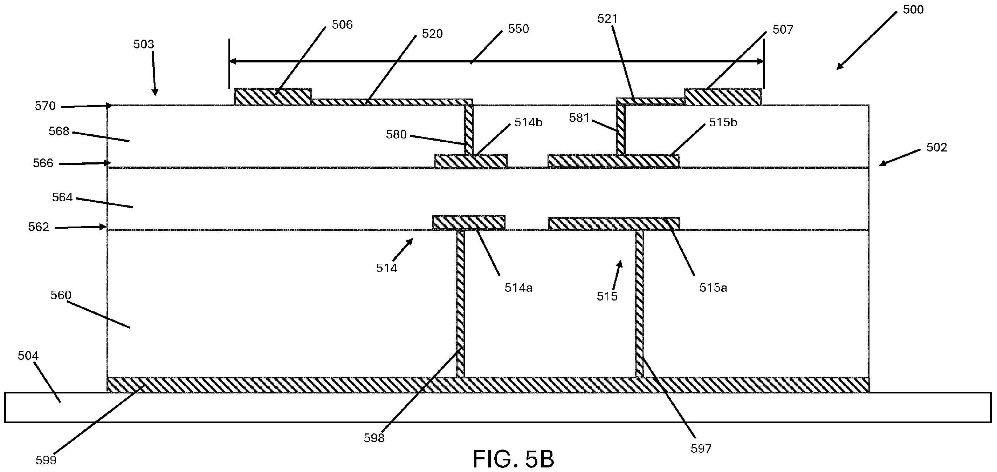

FIG. 5A depicts a device 500 for providing improved harmonic termination. FIG. 5B is a cross-sectional view of device 500 taken along line 5B-5B of FIG. 5A. Device 500 includes semiconductor die 502 (e.g., carrier amplifier die 132 or peaking amplifier die 152 of FIG. 1) mounted to substrate 504 (e.g., substrate 110 of FIG. 1). In some embodiments, the die 502 is more specifically mounted to a conductive feature of substrate, such as a conductive coin or thermal vias, which function as a ground node and/or thermal dissipation structure. In one or more embodiments, semiconductor die 502 includes a transistor (e.g., a GaN transistor or other type of transistor) configured to amplify an input RF signal.

Semiconductor die 502 includes a first bond pad 506 and a second bond pad 507 that are both configured to operate as an RF input terminals (e.g., RF input terminal 153 of FIG. 1) of semiconductor die 502. Bond pads 506 and 507 may, in one or more embodiment, be gate structures of the transistor of semiconductor die 502. Or, alternatively, may be distinct from, but electrically connected to (e.g., via a matching network) the transistor's gate structure. Semiconductor die 502 also includes bond pad 508 that is configured to operate as an RF output terminal (e.g., RF output terminal 158 or RF output terminal 138 of FIG. 1) of semiconductor die 502, for example, to output an amplified radio frequency signal.

On top surface 503 of semiconductor die 502, both bond pads 506 and 507 are formed within a region of top surface 503 designated as the input bond pad region 550. The input bond pad region 550 represents the portion of top surface 503 of semiconductor die 502 that, in a conventional application, would be reserved and allocated for a single input bond pad, as in the configuration of bond pad 206 of device 200 of FIG. 2.

As illustrated by FIG. 5A, however, the input bond pads 506 and 507 of device 500 occupy only a small portion of input bond pad region 550, leaving the remainder of the input bond pad region 550 and the portion of semiconductor die 502 below the input bond pad region 550 available for the fabrication of other components as described below. Input bond pad region 550 is generally of the size and shape of a conventional bond pad used in conjunction with semiconductor die 502. As such, input bond pad region 550 may, in one or more embodiment of the present disclosure, have the same or similar length and width as bond pad 508. According to one or more embodiments, no portion of the below-described harmonic filter circuit is outside a portion of the semiconductor die defined by the input bond pad region 550.

Wirebonds 510 and 511 are coupled to bond pads 506 and 507, respectively, and are configured to supply an input RF signal to bond pads 506 and 507 and the power transistor of semiconductor die 502. Specifically, bond pads 506 and 507 are each coupled to a gate or control terminal of the transistor of semiconductor die 502. Wirebonds 512 are similarly connected to bond pad 508 and are configured to route the amplifier RF output signal of semiconductor die 502 to other components (e.g., wirebonds 164 or wirebonds 142 of FIG. 1). Bond pad 508 is electrically coupled to the drain or output terminal of the transistor within semiconductor die 502.

During operation, the RF input signal that is supplied to bond pads 506 and 507 (i.e., the RF input terminal) of semiconductor die 502 includes harmonic components that should be terminated to enable efficient amplification of the signal by semiconductor die 502. Accordingly, a harmonic filter circuit is coupled to bond pads 506 and 507 that is configured to shunt those harmonic components to a ground node, effectively removing them from the signal that is amplified by semiconductor die 502.

As shown by FIG. 5B, semiconductor die 502 includes a number of layers, which may include alternating layers of semiconductor materials, dielectric materials, and patterned metal layers arranged or patterned to form the functional components of semiconductor die 502. Specifically, semiconductor die 502 includes a lower layer 560 of semiconductor material(s), which forms a base of semiconductor die 502, and a build-up structure over the lower layer 560. The build-up structure includes patterned metal layer 562 is formed over 560. Dielectric layer 564 is formed over metal layer 562 and metal layer 566 is formed over dielectric layer 564. Dielectric layer 568 is formed over metal layer 566 and metal layer 570 is formed over dielectric layer 568. Another conductive layer 599 may be formed on the bottom surface of the semiconductor die 502, and this layer functions as a ground reference node for the die 502.

Capacitor 514, which may be referred to as a "harmonic filter capacitor," is formed within a non-active area of the semiconductor die 502. Capacitor 514 is formed within metal layers 562 and 566 of semiconductor die 502 that are below top surface 503 of semiconductor die 502. Specifically, capacitor 514 includes a bottom plate 514a that is connected to a ground node (e.g., via a conductive network that may include, for example, a conductive through substrate via 598 that extends through layer 560 to conductive layer 599). Top plate 514b of capacitor 514 is connected, by via 580, to a first end of conductive trace 520 (e.g., which may be implemented as a linear conductor (as depicted) or, alternatively, as a spiral inductor), which is coupled at its other end to bond pad 506. Conductive trace 520 are formed on top surface 503 of semiconductor die 502 in metal layer 570.

Capacitor 515, which may be referred to as a "harmonic filter capacitor," is formed within a non-active area of the semiconductor die 502. Capacitor 515 is formed within metal layers 562 and 566 of semiconductor die 502 that are below top surface 503 of semiconductor die 502. Specifically, capacitor 515 includes a bottom plate 515a that is connected to a ground node (e.g., via a conductive network that may include, for example, a conductive through substrate via 597 that extends through layer 560 to the conductive layer 599). Top plate 515b of capacitor 515 is connected, by via 581, to a first end of conductive trace 521 (e.g., which may be implemented as a linear conductor (as depicted) or, alternatively, as a spiral inductor), which is coupled at its other end to bond pad 507. Conductive trace 521 is formed on top surface 503 of semiconductor die 502 in metal layer 570.

In this configuration, conductive trace 520 operates as an inductance, and thus trace 520 may be referred to herein as a "harmonic filter inductor". Together conductive trace 520 and capacitor 514 (which comprises two capacitor plates referred to as bottom plate 514a, top plate 514b, and a portion of dielectric layer 564 disposed between bottom plate 514a and top plate 514b) form a series inductance-capacitor shunt circuit. By designing the inductance of conductive trace 520 (and conductive via 580) and the capacitance of capacitor 514, conductive trace 520 and capacitor 514 work in conjunction as a harmonic filter circuit configured to shunt to a ground node any signals present at bond pad 506 that are at harmonic frequencies of the fundamental frequency of semiconductor die 502.

Similarly, conductive trace 521 operates as an inductance, and thus trace 521 may be referred to herein as a "harmonic filter inductor". Together, conductive trace 521 and capacitor 515 form a series inductance-capacitor shunt circuit. By designing the inductance of conductive trace 521 (and conductive via 581) and the capacitance of capacitor 515, conductive trace 521 and capacitor 515 work in conjunction as a harmonic filter circuit configured to shunt to a ground node any signals present at bond pad 507 that are at harmonic frequencies of the fundamental frequency of semiconductor die 502.

The harmonic filter circuits comprising conductive trace 520 and capacitor 514 and conductive trace 521 and capacitor 515 are, as illustrated in FIGS. 5A and 5B, incorporated into the body of semiconductor die 502. This enables better control over both the inductance values of conductive traces 520 and 521 as well as the capacitance of capacitors 514 and 515 to improve the efficiency and performance of semiconductor die 502, while further enabling the implement of two different harmonic filter circuits that may each be configured differently from one another (e.g., to provide selective termination of two different frequencies).

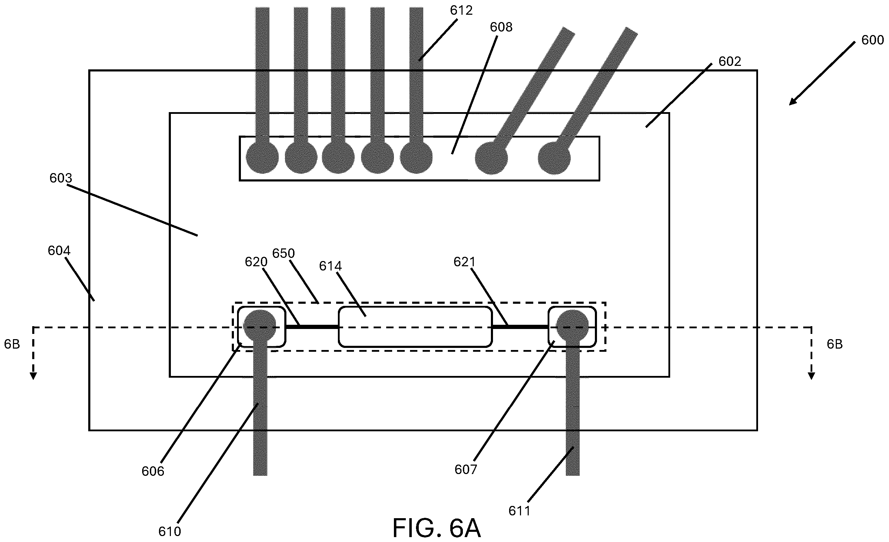

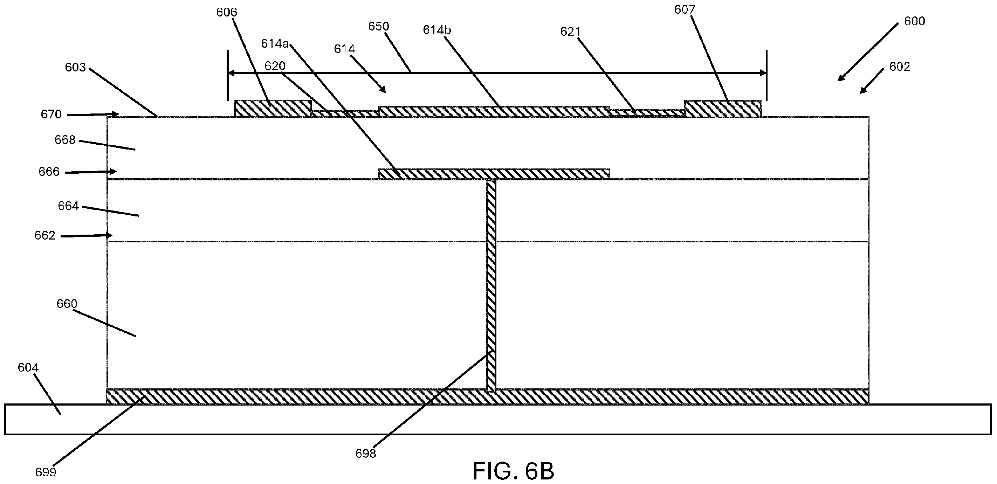

FIG. 6A depicts a device 600 for providing improved harmonic termination. FIG. 6B is a cross-sectional view of device 600 taken along line 6B-6B of FIG. 6A. Device 600 includes semiconductor die 602 (e.g., carrier amplifier die 132 or peaking amplifier die 152) mounted to substrate 604 (e.g., substrate 110 of FIG. 1). In some embodiments, the die 602 is more specifically mounted to a conductive feature of substrate, such as a conductive coin or thermal vias, which function as a ground node and/or thermal dissipation structure. In one or more embodiments, semiconductor die 602 includes a transistor (e.g., a GaN transistor or other type of transistor) configured to amplify an input RF signal.

Semiconductor die 602 includes a first bond pad 606 and a second bond pad 607 that are both configured to operate as an RF input terminals (e.g., RF input terminal 153 of FIG. 1) of semiconductor die 602. Bond pads 606 and 607 may, in one or more embodiment, be gate structures of the transistor of semiconductor die 602. Or, alternatively, may be distinct from, but electrically connected to (e.g., via a matching network) the transistor's gate structure. Semiconductor die 602 also includes bond pad 608 that is configured to operate as an RF output terminal (e.g., RF output terminal 158 or RF output terminal 138 of FIG. 1) of semiconductor die 602, for example, to output an amplified radio frequency signal.

On top surface 603 of semiconductor die 602, both bond pads 606 and 607 are formed within a region of top surface 603 designated as the input bond pad region 650. The input bond pad region 650 represents the portion of top surface 603 of semiconductor die 602 that, in a conventional application, would be reserved and allocated for a single input bond pad, as in the configuration of bond pad 206 of device 200 of FIG. 2.

As illustrated by FIG. 6A, however, the input bond pads 606 and 607 of device 600 occupy only a small portion of input bond pad region 650, leaving the remainder of the input bond pad region 650 and the portion of semiconductor die 602 below the input bond pad region 650 available for the fabrication of other components as described below. Input bond pad region 650 is generally of the size and shape of a conventional bond pad used in conjunction with semiconductor die 602. As such, input bond pad region 650 may, in various embodiments of the present disclosure, have the same or similar length and width as bond pad 608. According to one or more embodiments, no portion of the below-described harmonic filter circuit is outside a portion of the semiconductor die defined by the input bond pad region 650.

Wirebonds 610 and 611 are coupled to bond pads 606 and 607, respectively, and are configured to supply an input RF signal to bond pads 606 and 607 and the power transistor of semiconductor die 602. Specifically, bond pads 606 and 607 are each coupled to a gate or control terminal of the transistor of semiconductor die 602. Wirebonds 612 are similarly connected to bond pad 608 and are configured to route the amplifier RF output signal of semiconductor die 602 to other components (e.g., wirebonds 164 or wirebonds 142 of FIG. 1). Bond pad 608 is electrically coupled to the drain or output terminal of the transistor within semiconductor die 602.

During operation, the RF input signal that is supplied to bond pads 606 and 607 (i.e., the RF input terminal) of semiconductor die 602 includes harmonic components that should be terminated to enable efficient amplification of the signal by semiconductor die 602. Accordingly, a harmonic filter circuit is coupled to bond pads 606 and 607 that is configured to shunt those harmonic components to a ground node, effectively removing them from the signal that is amplified by semiconductor die 602.

Accordingly, capacitor 614 is formed within a non-active area of semiconductor die 602. As shown by FIG. 6B, semiconductor die 602 includes a number of layers, which may include alternating layers of semiconductor materials, dielectric materials, and patterned metal layers arranged or patterned to form the functional components of semiconductor die 602. Specifically, semiconductor die 602 includes a lower layer 660 of semiconductor material(s), which forms a base of semiconductor die 602, and a build-up structure over the lower layer 660. The build-up structure includes patterned metal layer 662 is formed over 660. Dielectric layer 664 is formed over metal layer 662 and metal layer 666 is formed over dielectric layer 664. Dielectric layer 668 is formed over metal layer 666 and metal layer 670 is formed over dielectric layer 668. Another conductive layer 699 may be formed on the bottom surface of the semiconductor die 602, and this layer functions as a ground reference node for the die 602.

Capacitor 614, which may be referred to as a "harmonic filter capacitor," is formed within metal layers 666 and 670 of semiconductor die 602. Specifically, capacitor 614 includes a bottom plate 614a that is connected to a ground node (e.g., via a conductive network that may include, for example, a conductive through substrate via 698 that extends through layers 660 and 664 to the conductive layer 699). Top plate 614b of capacitor 614 is connected to a first end of conductive trace 620 (e.g., which may be implemented as a linear conductor (as depicted) or, alternatively, as a spiral inductor), which is coupled at its other end to bond pad 606. Top plate 614b of capacitor 614 is connected to a first end of conductive trace 621 (e.g., which may be implemented as a linear conductor (as depicted) or, alternatively, as a spiral inductor), which is coupled at its other end to bond pad 607. Conductive traces 620 and 621 are formed at the top surface 603 of semiconductor die 602 in metal layer 670, in an embodiment, although they may be formed in underlying metal layers, as well.

In this configuration, conductive traces 620 and 621 operate as an inductance, and thus traces 620 and 621 may be referred to herein as "harmonic filter inductors". Together, conductive traces 620, 621, and capacitor 614 (which comprises two capacitor plates referred to as bottom plate 614a, top plate 614b, and a portion of dielectric layer 668 disposed between bottom plate 614a and top plate 614b) form a series inductance-capacitor shunt circuit. By designing the inductances of conductive traces 620 and 621 and the capacitance of capacitor 614, conductive traces 620, 621 and capacitor 614 work in conjunction as a harmonic filter circuit configured to shunt to a ground node any signals present at bond pads 606 and 607 that are at harmonic frequencies of the fundamental frequency of semiconductor die 602.

The harmonic filter circuits comprising conductive traces 620, 621, and capacitor 614 are, as illustrated in FIGS. 6A and 6B, incorporated into the body of semiconductor die 602. This enables better control over both the inductance values of conductive traces 620 and 621 as well as the capacitance of capacitor 614 to improve the efficiency and performance of semiconductor die 602.

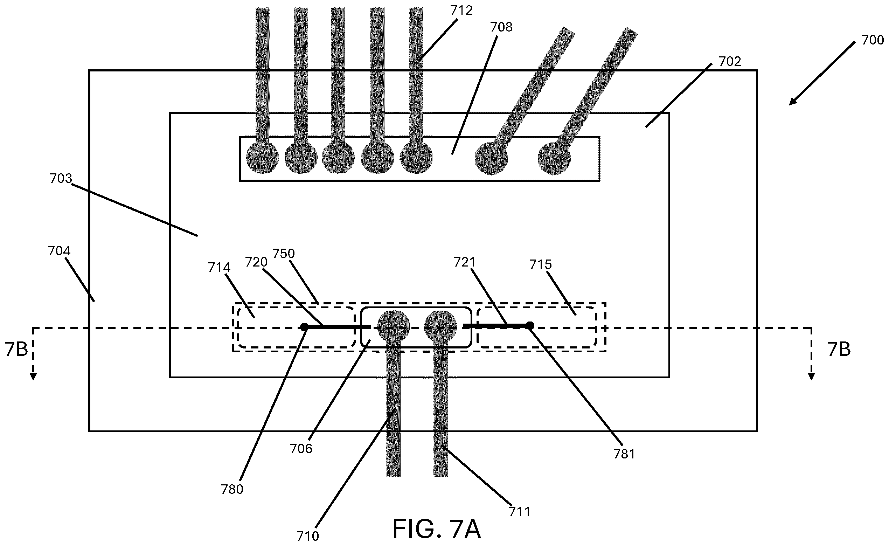

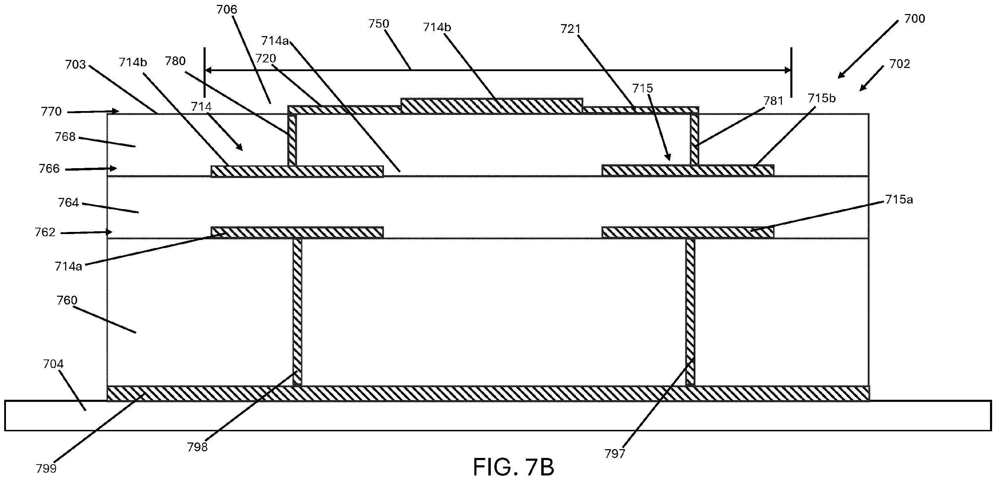

FIG. 7A depicts a device 700 for providing improved harmonic termination. FIG. 7B is a cross-sectional view of device 700 taken along line 7B-7B of FIG. 7A. Device 700 includes semiconductor die 702 (e.g., carrier amplifier die 132 or peaking amplifier die 152) mounted to substrate 704 (e.g., substrate 110 of FIG. 1). In some embodiments, the die 702 is more specifically mounted to a conductive feature of substrate, such as a conductive coin or thermal vias, which function as a ground node and/or thermal dissipation structure. In one or more embodiments, semiconductor die 702 includes a transistor (e.g., a GaN transistor or other type of transistor) configured to amplify an input RF signal.

Semiconductor die 702 includes bond pad 706 that is configured to operate as an RF input terminal (e.g., RF input terminal 153 of FIG. 1) of semiconductor die 702. Bond pads 706 may, in one or more embodiment, be a gate structure of the transistor of semiconductor die 702. Or, alternatively, may be distinct from, but electrically connected to (e.g., via a matching network) the transistor's gate structure. Semiconductor die 702 also includes bond pad 708 that is configured to operate as an RF output terminal (e.g., RF output terminal 158 or RF output terminal 138 of FIG. 1) of semiconductor die 702, for example, to output an amplified radio frequency signal.

On top surface 703 of semiconductor die 702, bond pad 706 is formed within a region of top surface 703 designated as the input bond pad region 750. The input bond pad region 750 represents the portion of top surface 703 of semiconductor die 702 that, in a conventional application, would be reserved and allocated for a single input bond pad, as in the configuration of bond pad 206 of device 200 of FIG. 2.

As illustrated by FIG. 7A, however, input bond pad 706 of device 700 occupies only a small portion of input bond pad region 750, leaving the remainder of the input bond pad region 750 and the portion of semiconductor die 702 below the input bond pad region 750 available for the fabrication of other components as described below. Input bond pad region 750 is generally of the size and shape of a conventional bond pad used in conjunction with semiconductor die 702. As such, input bond pad region 750 may, in various embodiments of the present disclosure, have the same or similar length and width as bond pad 708. According to one or more embodiments, no portion of the below-described harmonic filter circuit is outside a portion of the semiconductor die defined by the input bond pad region 750.

Wirebonds 710 and 711 are coupled to bond pad 706, respectively, and are configured to supply an input RF signal to bond pad 706 and the power transistor of semiconductor die 702. Specifically, bond pad 706 is coupled to a gate or control terminal of the transistor of semiconductor die 702. Wirebonds 712 are similarly connected to bond pad 708 and are configured to route the amplifier RF output signal of semiconductor die 702 to other components (e.g., wirebonds 164 or wirebonds 142 of FIG. 1). Bond pad 708 is electrically coupled to the drain or output terminal of the transistor within semiconductor die 702.

During operation, the RF input signal that is supplied to bond pad 706 (i.e., the RF input terminal) of semiconductor die 702 includes harmonic components that should be terminated to enable efficient amplification of the signal by semiconductor die 702. Accordingly, a harmonic filter circuit is coupled to bond pad 706 that is configured to shunt those harmonic components to a ground node, effectively removing them from the signal that is amplified by semiconductor die 702.

Accordingly, capacitors 714 and 715 are formed within a non-active area of semiconductor die 702. As shown by FIG. 7B, semiconductor die 702 includes a number of layers, which may include alternating layers of semiconductor materials, dielectric materials, and patterned metal layers arranged or patterned to form the functional components of semiconductor die 702. Specifically, semiconductor die 702 includes a lower layer 760 of semiconductor material(s), which forms a base of semiconductor die 702, and a build-up structure over the lower layer 760. The build-up structure includes patterned metal layer 762 is formed over 760. Dielectric layer 764 is formed over metal layer 762 and metal layer 766 is formed over dielectric layer 764. Dielectric layer 768 is formed over metal layer 766 and metal layer 770 is formed over dielectric layer 768. Another conductive layer 799 may be formed on the bottom surface of the semiconductor die 702, and this layer functions as a ground reference node for the die 702.

Capacitor 714, which may be referred to as a "harmonic filter capacitor," is formed within metal layers 762 and 766 of semiconductor die 702 that are below top surface 703 of semiconductor die 702. Specifically, capacitor 714 includes a bottom plate 714a in metal layer 762 that is connected to a ground node (e.g., via a conductive network that may include, for example, a conductive through substrate via 798 that extends through layer 760 to the conductive layer 799). Top plate 714b of capacitor 714 is formed in metal layer 766 and is connected, by via 780, to a first end of conductive trace 720 (e.g., which may be implemented as a linear conductor (as depicted) or, alternatively, as a spiral inductor), which is coupled at its other end to bond pad 706. Conductive trace 720 is formed on top surface 703 of semiconductor die 702 in metal layer 770.

Capacitor 715, which may be referred to as a "harmonic filter capacitor," is formed within metal layers 762 and 766 of semiconductor die 702 that are below top surface 703 of semiconductor die 702. Specifically, capacitor 715 includes a bottom plate 715a formed in metal layer 762 and that is connected to a ground node (e.g., via a conductive network that may include, for example, a conductive through substrate via 797 that extends through layer 760 to the conductive layer 799). Top plate 715b of capacitor 715 is formed in metal layer 766 and is connected, by via 781, to a first end of conductive trace 721 (e.g., which may be implemented as a linear conductor (as depicted) or, alternatively, as a spiral inductor), which is coupled at its other end to bond pad 706. Conductive trace 721 is formed on top surface 703 of semiconductor die 702 in metal layer 770.

In this configuration, conductive trace 720 operates as an inductance, and thus trace 720 may be referred to herein as a "harmonic filter inductor". Together, conductive trace 720 and capacitor 714 (which comprises two capacitor plates referred to as bottom plate f714a, top plate 714b) form a series inductance-capacitor shunt circuit. By designing the inductance of conductive trace 720 and the capacitance of capacitor 714, conductive trace 720 and capacitor 714 work in conjunction as a harmonic filter circuit configured to shunt to a ground node any signals present at bond pad 706 that are at harmonic frequencies of the fundamental frequency of semiconductor die 702.

Similarly, conductive trace 721 operates as an inductance, and thus trace 721 may be referred to herein as a "harmonic filter inductor". Together, conductive trace 721 and capacitor 715 form a series inductance-capacitor shunt circuit. By designing the inductance of conductive trace 721 and the capacitance of capacitor 715, conductive trace 721 and capacitor 715 work in conjunction as a harmonic filter circuit configured to shunt to a ground node any signals present at bond pad 706 that are at harmonic frequencies of the fundamental frequency of semiconductor die 72.

The harmonic filter circuits comprising conductive trace 720 and capacitor 714 and conductive trace 721 and capacitor 715 are, as illustrated in FIGS. 7A and 7B, incorporated into the body of semiconductor die 702. This enables better control over both the inductance values of conductive traces 720 and 721 as well as the capacitance of capacitors 714 and 715 to improve the efficiency and performance of semiconductor die 702 while also enabling the implementation of two independent filter circuits that may each be configured to target different frequencies.

In various amplifier embodiments, the inductance of the various inductances and capacitance of the various capacitors is selected to achieved a desired harmonic termination characteristic. A primary variable in determining these inductance and capacitance values is the operating frequency of the amplifier itself. For example, in an amplifier operating at, 2.6 GigaHertz (GHz), for example, second order harmonics appear at a frequency of 5.2 GHz. In that arrangement, the harmonic filter capacitor may have a capacitance ranging from 5 picoFarads (pF) to 10 pF (though other ranges may be used, as necessary) and an inductance ranging from 90 picoHenries (pH) to 190 (pH) (though other ranges may be used, such as 1 pH to 200 pH, as necessary). Alternatively, for an amplifier operating at, 3.6 GHz, for example, second order harmonics appear at a frequency of 7.2 GHz. In that arrangement, the harmonic filter capacitor may have a capacitance ranging from 5 picoFarads (pF) to 10 pF (though other ranges may be used, as necessary) and an inductance ranging from 40 picoHenries (pH) to 190 (pH) (though other ranges may be used, such as 1 pH to 200 pH, as necessary).

In some aspects, the techniques described herein relate to a semiconductor die, including: a transistor, including: a source region, a drain region, a channel between the source region and the drain region, a gate structure overlying the channel, wherein an electrical voltage applied to the gate structure is configured to control a conductivity of the channel, and a first gate terminal electrically connected to the gate structure; a first harmonic filter inductor formed in a body of the semiconductor die, wherein the first harmonic filter inductor is electrically connected to the first gate terminal; and a first harmonic filter capacitor formed in the body of the semiconductor die, the first harmonic filter capacitor including a first capacitor plate electrically connected to the first harmonic filter inductor and a second capacitor plate connected to a ground reference node.

In some aspects, the techniques described herein relate to a semiconductor die, further including: a second gate terminal electrically connected to the gate structure and electrically isolated from the first gate terminal; a second harmonic filter inductor formed in the body of the semiconductor die and electrically connected to the second gate terminal.

In some aspects, the techniques described herein relate to a semiconductor die, wherein the second harmonic filter inductor is electrically connected to the first capacitor plate.

In some aspects, the techniques described herein relate to a semiconductor die, further including a second harmonic filter capacitor formed in the body of the semiconductor die, wherein the second harmonic filter inductor is electrically connected to the second harmonic filter capacitor.

In some aspects, the techniques described herein relate to a semiconductor die, wherein the first harmonic filter inductor is configured as a spiral inductor.

In some aspects, the techniques described herein relate to a semiconductor die, wherein the transistor is a gallium nitride (GaN) field effect transistor.

In some aspects, the techniques described herein relate to a semiconductor die, wherein the first harmonic filter inductor has an inductance in a range of 1 picoHenry to 200 picoHenries.

In some aspects, the techniques described herein relate to a semiconductor die, wherein the first harmonic filter capacitor has a capacitance in a range of 5 picoFarads to 10 picoFarads.

In some aspects, the techniques described herein relate to a semiconductor die, further including an output terminal configured to output an amplified radio frequency signal from the semiconductor die, wherein the output terminal occupies a first region of a top surface of the semiconductor die and wherein the first gate terminal, the first harmonic filter inductor, and the first harmonic filter capacitor are formed within or below a second region of the top surface of the semiconductor die and a first size of the second region is equal to or less than a second size of the first region.

In some aspects, the techniques described herein relate to a semiconductor die, wherein no portion of the first harmonic filter inductor or the first harmonic filter capacitor is outside a portion of the semiconductor die defined by the second region.

In some aspects, the techniques described herein relate to a Doherty amplifier, including: a substrate; an input terminal configured to receive an amplified radio frequency signal; a signal splitter electrically connected to the input terminal and configured to output a first output signal and a second output signal; a semiconductor die on the substrate, wherein the semiconductor die includes: a transistor, a first input bond pad electrically connected to the signal splitter and configured to receive the first output signal, a first harmonic filter inductor formed in a body of the semiconductor die, wherein the first harmonic filter inductor is electrically connected to the first input bond pad, and a first harmonic filter capacitor formed in the body of the semiconductor die, the first harmonic filter capacitor including a first capacitor plate electrically connected to the first harmonic filter inductor.

In some aspects, the techniques described herein relate to a Doherty amplifier, wherein the semiconductor die further includes: a second input bond pad electrically connected to the signal splitter and configured to receive the first output signal and electrically isolated from the first input bond pad; a second harmonic filter inductor electrically connected to the second input bond pad.

In some aspects, the techniques described herein relate to a Doherty amplifier, wherein the second harmonic filter inductor is electrically connected to the first capacitor plate.

In some aspects, the techniques described herein relate to a Doherty amplifier, further including a second harmonic filter capacitor formed in the body of the semiconductor die, wherein the second harmonic filter inductor is electrically connected to the second harmonic filter capacitor.

In some aspects, the techniques described herein relate to a Doherty amplifier, wherein the semiconductor die includes an output bond pad, wherein the output bond pad occupies a first region of a top surface of the semiconductor die and wherein the first input bond pad, the first harmonic filter inductor, and the first harmonic filter capacitor are formed within or below a second region of the top surface of the semiconductor die and a first size of the second region is equal to or less than a second size of the first region.

In some aspects, the techniques described herein relate to a Doherty amplifier, wherein no portion of the first harmonic filter inductor or the first harmonic filter capacitor is outside a portion of the semiconductor die defined by the second region.

In some aspects, the techniques described herein relate to an electronic device, including: a substrate; an input terminal configured to receive an amplified radio frequency signal; a signal splitter electrically connected to the input terminal and configured to output a first output signal and a second output signal; a first semiconductor die on the substrate, wherein the first semiconductor die includes: a first transistor, a first input bond pad electrically connected to the signal splitter to receive the first output signal, and a first harmonic filter formed in a body of the first semiconductor die, wherein the first harmonic filter is electrically connected to the first input bond pad; and a second semiconductor die on the substrate, wherein the second semiconductor die includes: a second transistor, a second input bond pad electrically connected to the signal splitter to receive the second output signal, and a second harmonic filter formed in the body of the second semiconductor die, wherein the second harmonic filter is electrically connected to the second input bond pad.

In some aspects, the techniques described herein relate to an electronic device, wherein the first semiconductor die includes a third input bond pad electrically connected to the signal splitter to receive the first output signal, wherein the first harmonic filter is electrically connected to the third input bond pad.

In some aspects, the techniques described herein relate to an electronic device, wherein the first semiconductor die includes an output bond pad that occupies a first region of a top surface of the first semiconductor die and wherein the first input bond pad and the first harmonic filter are formed within or below a second region of the top surface of the first semiconductor die and a first size of the second region is equal to or less than a second size of the first region.

In some aspects, the techniques described herein relate to an electronic device, wherein no portion of the first harmonic filter is outside a portion of the first semiconductor die defined by the second region.

As will be appreciated by one skilled in the art, aspects of the present disclosure may be embodied as a system, process, method, and/or program product.

The block diagrams in the figures illustrate architecture, functionality, and operation of possible implementations of circuitry, systems, methods, processes, and program products according to various embodiments of the present disclosure. In this regard, certain blocks in the block diagrams may represent a module, segment, or portion of code, which includes one or more executable program instructions for implementing the specified logical function(s). It should also be noted that, in some implementations, the functions noted in the blocks may occur out of the order noted in the figures. For example, two blocks shown in succession may, in fact, be executed substantially concurrently, or the blocks may sometimes be executed in the reverse order, depending upon the functionality involved.

Modules implemented in software for execution by various types of processors may, for instance, include one or more physical or logical blocks of computer instructions, which may, for instance, be organized as an object, procedure, or function. Nevertheless, the executables of an identified module need not be physically located together, but may include disparate instructions stored in different locations which, when joined logically together, include the module, and achieve the stated purpose for the module. Indeed, a module of executable code may be a single instruction, or many instructions, and may even be distributed over several different code segments, among different programs, and across several memory devices. Similarly, operational data (e.g., knowledge bases of adapted weights and/or biases described herein) may be identified and illustrated herein within modules, and may be embodied in any suitable form and organized within any suitable type of data structure. The operational data may be collected as a single data set, or may be distributed over different locations including over different storage devices. The data may provide electronic signals on a system or network.

These program instructions may be provided to one or more processors and/or controller(s) of a general-purpose computer, special purpose computer, or other programmable data processing apparatus (e.g., controller) to produce a machine, such that the instructions, which execute via the processor(s) of the computer or other programmable data processing apparatus, create circuitry or means for implementing the functions/acts specified in the block diagram block or blocks.

It will also be noted that each block of the block diagrams, and combinations of blocks in the block diagrams, can be implemented by special purpose hardware-based systems (e.g., which may include one or more graphics processing units) that perform the specified functions or acts, or combinations of special purpose hardware and computer instructions. For example, a module may be implemented as a hardware circuit including custom VLSI circuits or gate arrays, off-the-shelf semiconductors such as logic chips, transistors, controllers, or other discrete components. A module may also be implemented in programmable hardware devices such as field programmable gate arrays, programmable array logic, programmable logic devices, application specific ICs, microcontrollers, systems on a chip, general purpose processors, microprocessors, or the like.

The preceding detailed description is merely illustrative in nature and is not intended to limit the embodiments of the subject matter or the application and uses of such embodiments.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor die, comprising:
a transistor, including:
a source region,
a drain region,
a channel between the source region and the drain region,
a gate structure overlying the channel, wherein an electrical voltage applied to the gate structure is configured to control a conductivity of the channel, and
a first gate terminal electrically connected to the gate structure;
a first harmonic filter inductor formed in a body of the semiconductor die, wherein the first harmonic filter inductor is electrically connected to the first gate terminal; and
a first harmonic filter capacitor formed in the body of the semiconductor die, the first harmonic filter capacitor including a first capacitor plate electrically connected to the first harmonic filter inductor and a second capacitor plate connected to a ground reference node.

2. The semiconductor die of claim 1, further comprising:
a second gate terminal electrically connected to the gate structure and electrically isolated from the first gate terminal;
a second harmonic filter inductor formed in the body of the semiconductor die and electrically connected to the second gate terminal.

3. The semiconductor die of claim 2, wherein the second harmonic filter inductor is electrically connected to the first capacitor plate.

4. The semiconductor die of claim 3, further comprising a second harmonic filter capacitor formed in the body of the semiconductor die, wherein the second harmonic filter inductor is electrically connected to the second harmonic filter capacitor.

5. The semiconductor die of any preceding claim, wherein the first harmonic filter inductor is configured as a spiral inductor.

6. The semiconductor die of any preceding claim, wherein the transistor is a gallium nitride, GaN, field effect transistor.

7. The semiconductor die of claim 6, wherein the first harmonic filter inductor has an inductance in a range of 1 picoHenry to 200 picoHenries.

8. The semiconductor die of claim 6 or 7, wherein the first harmonic filter capacitor has a capacitance in a range of 5 picoFarads to 10 picoFarads.

9. The semiconductor die of any preceding claim 1, further comprising an output terminal configured to output an amplified radio frequency signal from the semiconductor die, wherein the output terminal occupies a first region of a top surface of the semiconductor die and wherein the first gate terminal, the first harmonic filter inductor, and the first harmonic filter capacitor are formed within or below a second region of the top surface of the semiconductor die and a first size of the second region is equal to or less than a second size of the first region.

10. The semiconductor die of claim 9, wherein no portion of the first harmonic filter inductor or the first harmonic filter capacitor is outside a portion of the semiconductor die defined by the second region.

11. A Doherty amplifier, comprising:
a substrate;
an input terminal configured to receive an amplified radio frequency signal;
a signal splitter electrically connected to the input terminal and configured to output a first output signal and a second output signal;
a semiconductor die, on the substrate and as claimed in any preceding claim.

12. The Doherty amplifier of claim 11, wherein the semiconductor die further includes:
a second input bond pad electrically connected to the signal splitter and configured to receive the first output signal and electrically isolated from the first input bond pad;
a second harmonic filter inductor electrically connected to the second input bond pad.

13. The Doherty amplifier of claim 12, further comprising a second harmonic filter capacitor formed in the body of the semiconductor die, wherein the second harmonic filter inductor is electrically connected to the second harmonic filter capacitor.

14. The Doherty amplifier of any of claims 11 to 13, wherein the semiconductor die includes an output bond pad, wherein the output bond pad occupies a first region of a top surface of the semiconductor die and wherein the first input bond pad, the first harmonic filter inductor, and the first harmonic filter capacitor are formed within or below a second region of the top surface of the semiconductor die and a first size of the second region is equal to or less than a second size of the first region.

15. The Doherty amplifier of claim 14, wherein no portion of the first harmonic filter inductor or the first harmonic filter capacitor is outside a portion of the semiconductor die defined by the second region.
